# EUROPEAN PATENT APPLICATION

(11) **EP 4 801 225 A1**
(43) Date of publication of application: **02.09.2026**
(21) Application number: 25215039.6
(22) Date of filing: 11.11.2025
(51) Int. Cl.: H10F 39/18, H10F 39/00

(54) **IMAGE SENSING DEVICE**

(30) Priority: 27.02.2025 KR 20250026137
(71) Applicant: SK hynix Inc., Bubal-eub Icheon-si Gyeonggi-do 17336 (KR)
(72) Inventor: CHO, Sung Wook, 17336 Icheon-si, Gyeonggi-do (KR)
(74) Representative: Isarpatent

(57) **Abstract**

Image sensing devices including pixel isolation structures are disclosed. In an embodiment, an image sensing device includes a first pixel and a second pixel. The first pixel includes a first photoelectric conversion region configured to detect light of a first wavelength range, and a first pixel isolation structure that surrounds the first photoelectric conversion region and has a first width. The second pixel includes a second photoelectric conversion region configured to detect light of the first wavelength range, and a second pixel isolation structure that surrounds the second photoelectric conversion region and has a second width smaller than the first width.

## Description

### TECHNICAL FIELD

The technology and embodiments disclosed in this patent document generally relate to an image sensing device, and more particularly to an image sensing device including one or more pixel isolation structures.

### BACKGROUND

An image sensing device can capture optical images by converting light into electrical signals using a photosensitive semiconductor material that reacts to light. With advancements in industries such as automotive, medical, computer and communication industries, the demand for high-performance image sensing devices is growing across various fields, such as smartphones, digital cameras, game machines, IoT (Internet of Things), robots, security cameras and medical micro cameras.

The image sensing device may be roughly divided into charge coupled device (CCD) image sensing devices and complementary metal oxide semiconductor (CMOS) image sensing devices. CCD image sensing devices offer a better image quality, but they tend to consume more power and are larger as compared to CMOS image sensing devices. CMOS image sensing devices are smaller in size and consume less power than CCD image sensing devices. Furthermore, CMOS image sensing devices are fabricated using the CMOS fabrication technology, and thus photosensitive elements and other signal processing circuitry can be integrated into a single chip, enabling the production of miniaturized image sensing devices at a lower cost. For these reasons, CMOS image sensing devices are being developed for many applications including mobile devices.

### SUMMARY

Various embodiments of the disclosed technology relate to an image sensing device that includes pixels with different sensitivities to light within the same wavelength range, without the need for a separate complex circuit.

In an embodiment of the disclosed technology, an image sensing device may include a first pixel and a second pixel. The first pixel includes: a first photoelectric conversion region configured to detect light of a first wavelength range; and a first pixel isolation structure that surrounds the first photoelectric conversion region and has a first width. The second pixel includes a second photoelectric conversion region configured to detect light of the first wavelength range; and a second pixel isolation structure that surrounds the second photoelectric conversion region and has a second width smaller than the first width.

In some implementations, the image sensing device may further include: a grid structure disposed on the first and second pixel isolation structures at a boundary between the first pixel and the second pixel, wherein the first and second pixel isolation structures are in contact with each other.

In some implementations, the grid structure may include an air region.

In some implementations, the first pixel may include a first color filter that selectively transmits light of the first wavelength range from among incident light; and the second pixel may include a second color filter that selectively transmits light of the first wavelength range from among the incident light, wherein the grid structure is disposed between the first color filter and the second color filter.

In some implementations, the image sensing device may further include a third pixel and a fourth pixel. The third pixel includes a third photoelectric conversion region configured to detect light of the second wavelength range; and a third pixel isolation structure that includes the third photoelectric conversion region and has the first width. The fourth pixel includes a fourth photoelectric conversion region configured to detect light of the second wavelength range; and a fourth pixel isolation structure that includes the fourth photoelectric conversion region and has the second width.

In some implementations, the first pixel may include: a fifth photoelectric conversion region configured to detect light of the first wavelength range; and a first protrusion disposed between the first photoelectric conversion region and the fifth photoelectric conversion region and configured to contact the first pixel isolation structure.

In some implementations, the second pixel may include: a sixth photoelectric conversion region configured to detect light of the first wavelength range; and a second protrusion disposed between the second photoelectric conversion region and the sixth photoelectric conversion region and configured to contact the second pixel isolation structure.

In some implementations, the first pixel may include: seventh and eighth photoelectric conversion regions configured to detect light of the first wavelength range; a second protrusion disposed between the first photoelectric conversion region and the seventh photoelectric conversion region; a third protrusion disposed between the fifth photoelectric conversion region and the eighth photoelectric conversion region; and a fourth protrusion disposed between the seventh photoelectric conversion region and the eighth photoelectric conversion region, wherein each of the second to fourth protrusions extends from the first pixel isolation structure toward a center of the first pixel.

In some implementations, the first pixel and the second pixel may be in contact with each other; and the third pixel and the fourth pixel may be in contact with each other.

In some implementations, the third pixel may have a lower sensitivity than the fourth pixel.

In another embodiment of the disclosed technology, an image sensing device may include: a first pixel group including first and second pixels configured to detect light of a first wavelength range. The first pixel may include a first pixel isolation structure surrounding a first active region upon which light of the first wavelength range is incident. The second pixel may include a second pixel isolation structure surrounding a second active region upon which light of the first wavelength range is incident. The second pixel isolation structure may have a smaller area than the first pixel isolation structure.

In some implementations, the second active region may have a larger area than the first active region.

In some implementations, the second pixel may have a higher fill factor than the first pixel.

In some implementations, the first pixel may further include a first protrusion configured to extend from the first pixel isolation structure to a center of the first pixel in a first direction. The second pixel may further include a second protrusion configured to extend from the second pixel isolation structure to the inside of the second pixel in the first direction.

In some implementations, the first pixel may further include a third protrusion configured to extend from the first pixel isolation structure to the inside of the second pixel in a second direction. The second pixel may further include a second protrusion configured to extend from the second pixel isolation structure to the inside of the second pixel in the second direction.

In some implementations, the first pixel group may further include third and fourth pixels configured to detect light of the first wavelength range. The third pixel may include a third pixel isolation structure configured to surround a third active region upon which light of the first wavelength range is incident. The fourth pixel may include a fourth pixel isolation structure configured to surround a fourth active region upon which light of the first wavelength range is incident. Each of the third and fourth pixel isolation structures may have a smaller area than the first pixel isolation structure.

In some implementations, the first to fourth pixels may be arranged in a (2 × 2) matrix configuration, the first pixel isolation structure may contact the second and third pixel isolation structures, and the fourth pixel isolation structure may contact the second and third pixel isolation structures.

In some implementations, each of the third and fourth active regions may have a larger area than the first active region.

In some implementations, each of the third and fourth pixels may have a higher fill factor than the first pixel.

In some implementations, the image sensing device may further include a second pixel group including fifth and sixth pixels that detect light of a second wavelength range and configured to contact the first pixel group. The fifth pixel may include a fifth pixel isolation structure configured to surround a fifth active region upon which light of the second wavelength range is incident, the sixth pixel may include a sixth pixel isolation structure configured to surround a sixth active region upon which light of the second wavelength range is incident; and the sixth pixel isolation structure may have a smaller area than the fifth pixel isolation structure.

In some implementations, the sixth active region may have a larger area than the fifth active region.

In some implementations, the sixth active region may have a higher fill factor than the fifth active region.

It is to be understood that both the foregoing general description and the following detailed description of the disclosed technology are illustrative and explanatory and are intended to provide further explanation of the disclosure as claimed.

### BRIEF DESCRIPTION OF THE DRAWINGS

The above and other features and beneficial aspects of the disclosed technology will become readily apparent with reference to the following detailed description when considered in conjunction with the accompanying drawings.
FIG. 1 is a block diagram illustrating an example of an image sensing device based on some implementations of the disclosed technology.
FIG. 2 is a plan view illustrating an example of a pixel array of the image sensing device shown in FIG. 1 based on some implementations of the disclosed technology.
FIG. 3 is a circuit diagram illustrating a first embodiment of a pixel region shown in FIG. 2 based on some implementations of the disclosed technology.
FIG. 4 is a cross-sectional view illustrating an example of the pixel region taken along the line A-A' shown in FIG. 3 based on some implementations of the disclosed technology.
FIG. 5 is a circuit diagram illustrating a second embodiment of the pixel region shown in FIG. 2 based on some implementations of the disclosed technology.
FIG. 6 is a cross-sectional view illustrating an example of the pixel region taken along the line B-B' shown in FIG. 5 based on some implementations of the disclosed technology.
FIG. 7 is a circuit diagram illustrating a third embodiment of the pixel region shown in FIG. 2 based on some implementations of the disclosed technology.

### DETAILED DESCRIPTION

This patent document provides embodiments and examples of an image sensing device including one or more pixel isolation structures that may be used in configurations to substantially address one or more technical or engineering issues and to mitigate limitations or disadvantages encountered in some image sensing devices in the art. Some embodiments of the disclosed technology relate to an image sensing device that can implement pixels having different sensitivities with respect to light of the same wavelength range without designing a separate complex circuit. In recognition of the issues above, the image sensing device based on some embodiments of the disclosed technology may enable pixels that detect light beams within the same wavelength range to exhibit different sensitivities to light without requiring a separate complex circuit, thereby enabling the implementation of a high dynamic range (HDR) imaging.

Reference will now be made in detail to the embodiments of the disclosed technology, examples of which are illustrated in the accompanying drawings. Wherever possible, the same reference numbers will be used throughout the drawings to refer to the same or like parts. While the disclosure is susceptible to various modifications and alternative forms, specific embodiments thereof are shown by way of example in the drawings. However, the disclosure should not be construed as being limited to the embodiments set forth herein.

Hereinafter, various embodiments will be described with reference to the accompanying drawings. However, it should be understood that the disclosed technology is not limited to specific embodiments, but includes various modifications, equivalents and/or alternatives of the embodiments. The embodiments of the disclosed technology may provide a variety of effects capable of being directly or indirectly recognized through the disclosed technology.

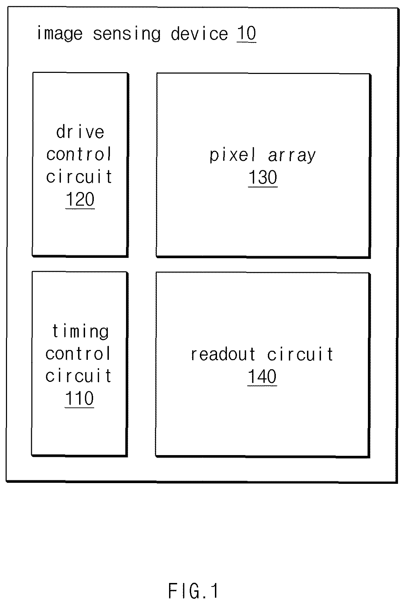

FIG. 1 is a schematic diagram illustrating an example of an image sensing device 10 based on some embodiments of the disclosed technology.

Referring to FIG. 1, the image sensing device 10 may include a timing control circuit 110, a pixel array 130, and a readout circuit 140. The constituent components of the image sensing device 10 illustrated in FIG. 1 are discussed by way of example only, and this patent document encompasses numerous other changes, substitutions, variations, alterations, and modifications. In this patent document, the word "pixel" can be used to indicate an image sensing pixel that is structured to detect incident light to generate electrical signals carrying images in the incident light. For example, the image sensing device 10 may be a Complementary Metal Oxide Semiconductor (CMOS) image sensor configured to convert incident light into an electrical signal.

The timing control circuit 110 may generate a timing signal to control the drive control circuit 120 and the readout circuit 140. In some implementations, the timing control circuit 110 may generate a timing signal according to a request from an external processor (e.g., an image signal processor ISP). In some implementations, the timing control circuit 110 may include a logic control circuit, a phase-locked loop (PLL) circuit, a communication interface circuit, etc.

The drive control circuit 120 may drive the pixels of the pixel array 130 in response to the timing signal output from the timing control circuit 110. The drive control circuit 120 may select and control pixels (PXs) included in at least one row line from among a plurality of row lines of the pixel array 130. The drive control circuit 120 may generate a row selection signal to select at least one row from among the plurality of rows. The drive control circuit 120 may sequentially enable a pixel reset signal and a transfer signal for pixels (PX) corresponding to at least one selected row. Accordingly, an analog reference signal and an image signal generated from each of the pixels (PXs) of the selected row may be sequentially transmitted to the readout circuit 140. The reference signal may be an electrical signal provided to the readout circuit 140 when a floating diffusion region (FD) of each pixel is reset to a power-supply voltage (VDD). The image signal may be an electrical signal provided to the readout circuit 140 when photocharges generated by each pixel are accumulated in the floating diffusion region (FD). The reference signal indicating unique pixel noise of each pixel, and the image signal indicating the intensity of incident light may be collectively referred to as a pixel signal as necessary.

The pixel array 130 may include a plurality of pixels (PXs) arranged in rows and columns. In one example, the plurality of pixels (PXs) can be arranged in a two-dimensional (2D) pixel array including rows and columns. In another example, the plurality of pixels (PXs) can be arranged in a three-dimensional (3D) pixel array. The plurality of pixels (PXs) may convert an optical signal into an electrical signal on a pixel basis or a pixel group basis, and may output a pixel signal. Here, the pixels in a pixel group of the pixel array 130 may share at least certain internal circuitry. The pixel array 130 may receive driving signals including a row selection signal, a pixel reset signal, a transfer signal, etc. from the drive control circuit 120. Upon receiving the driving signals, corresponding imaging pixels in the pixel array 130 may be activated to perform the operations corresponding to the row selection signal, the pixel reset signal, and the transfer signal.

The readout circuit 140 may detect a pixel signal output from the pixel array 130 under the control of the timing control circuit 110, and may output the detected pixel signal as image data. The image data may be digital data generated by performing an analog-to-digital conversion process on an analog pixel signal. To this end, the readout circuit 140 may include a correlated double sampler (CDS) for performing correlated double sampling on pixel signals output from the pixel array 130. In addition, the readout circuit 140 may include an analog-to-digital converter (ADC) for converting signals output from the correlated double sampler (CDS) into digital signals to generate pixel data. In addition, the readout circuit 140 may include a buffer circuit for temporarily storing pixel data output from the analog-to-digital converter (ADC) and outputting the stored pixel data to the outside under the control of the timing control circuit 110. The correlated double sampler (CDS) may remove the undesired offset value of pixels by comparing pixel output voltages obtained before and after photocharges generated by incident light are accumulated in the floating diffusion region (FD) so that only pixel output voltages based on the incident light can be measured. The readout circuit 140 may sequentially sample and hold voltage levels of the reference signal and the image signal, which are provided to each of a plurality of column lines from the pixel array 130. That is, the readout circuit 140 may sample and hold the voltage levels of the reference signal and the image signal which correspond to each of the columns of the pixel array 130. The readout circuit 140 may convert a correlated double sampler (CDS) signal, which is an analog signal for each column, into a digital signal, and may output the digital signal for each column. The readout circuit 140 may temporarily hold image data for each column, and may output the image data to, for example, an image processing device (not shown).

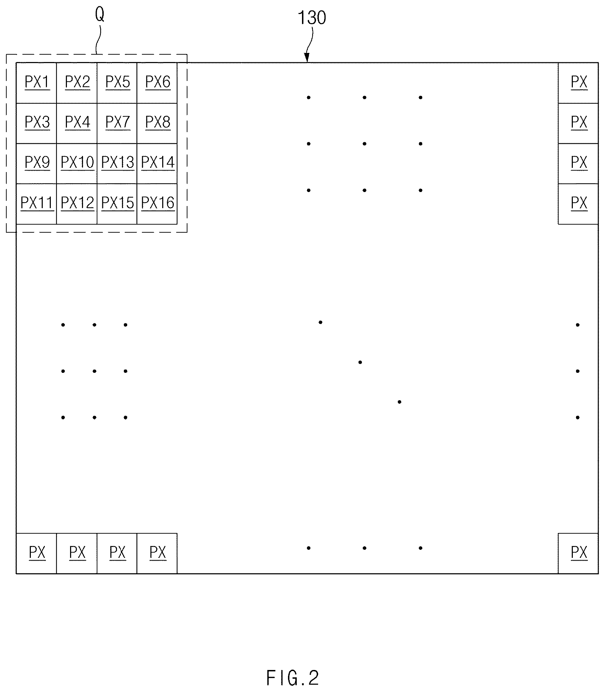

FIG. 2 is a plan view illustrating an example of the pixel array 130 of the image sensing device 10 shown in FIG. 1 based on some implementations of the disclosed technology.

Referring to FIGS. 1 and 2, the pixel array 130 may include, for example, a structure in which a plurality of pixels (PXs) is arranged in a two-dimensional (2D) matrix. The pixel array 130 may include M pixels (PXs) arranged in a horizontal direction (row direction), where M is an integer greater than or equal to 2. The pixel array 130 may include N pixels (PXs) arranged in a vertical direction, where N is an integer greater than or equal to 2.

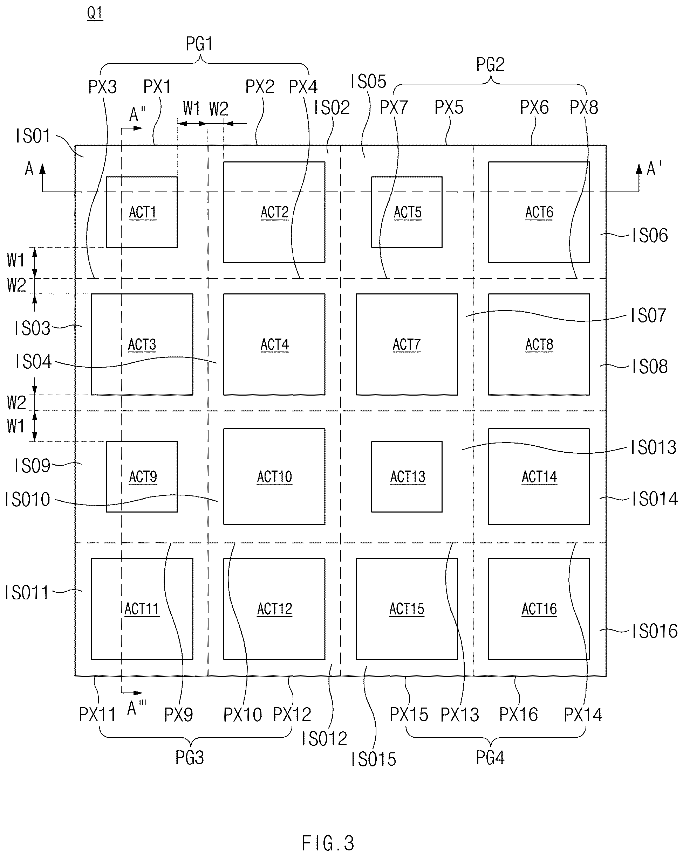

The pixel array 130 may include a pixel region (Q) including, e.g., first to sixteenth pixels (PX1-PX16). In some implementations, the pixel region (Q) may be a region in which 16 pixels are arranged in a (4 × 4) matrix configuration. More detailed embodiments of the pixel region (Q) will be described with reference to FIG. 3 and below.

FIG. 3 is a circuit diagram illustrating a first embodiment of the pixel region (Q) shown in FIG. 2 based on some implementations of the disclosed technology.

Referring to FIGS. 2 and 3, the pixel region (Q1) based on an embodiment may include first to fourth pixel groups (PG1-PG4). The first to fourth pixel groups (PG1-PG4) may be arranged in a (2 × 2) matrix configuration.

The first pixel group (PG1) may include first to fourth pixels (PX1-PX4). For example, the first to fourth pixels (PX1-PX4) may be arranged in a (2 × 2) matrix configuration. Each of the first to fourth pixels (PX1-PX4) may include a microlens (not shown) that converges incident light onto a photoelectric conversion region. Each of the first to fourth pixels (PX1-PX4) may include a color filter (not shown) that selectively transmits light (e.g., green light) having a first wavelength range (e.g., 500 nm to 600 nm). The first to fourth pixels (PX1 to PX4) may detect light of the first wavelength range. For example, each of the first to fourth pixels (PX1-PX4) may include a photoelectric conversion region that detects light of the first wavelength range.

The first pixel (PX1) may include a first active region (ACT1) and a first pixel isolation structure (ISO1) surrounding the first active region (ACT1). The first active region (ACT1) may include a first photoelectric conversion region (not shown). The first pixel isolation structure (ISO1) may also surround the first photoelectric conversion region. The first pixel isolation structure (ISO1) may have a first width (W1).

The second pixel (PX2) may include a second active region (ACT2) and a second pixel isolation structure (ISO2) surrounding the second active region (ACT2). The second active region (ACT2) may include a second photoelectric conversion region (not shown). The second pixel isolation structure (ISO2) may also surround the second photoelectric conversion region. The second pixel isolation structure (ISO2) may have a second width (W2). The second width (W2) may be smaller than the first width (W1). As a result, the first photoelectric conversion region has a smaller light-receiving area than the second photoelectric conversion region. Therefore, the first photoelectric conversion region has a lower optical sensitivity than the second photoelectric conversion region.

The third pixel (PX3) may include a third active region (ACT3) and a third pixel isolation structure (ISO3) surrounding the third active region (ACT3). The third active region (ACT3) may include a third photoelectric conversion region (not shown). The third pixel isolation structure (ISO3) may also surround the third photoelectric conversion region. The third pixel isolation structure (ISO3) may have a second width (W2).

The fourth pixel (PX4) may include a fourth active region (ACT4) and a fourth pixel isolation structure (ISO4) surrounding the fourth active region (ACT4). The fourth active region (ACT4) may include a fourth photoelectric conversion region (not shown). The fourth pixel isolation structure (ISO4) may also surround the third photoelectric conversion region. The fourth pixel isolation structure (ISO4) may have a second width (W2).

The second pixel group (PG2) may contact one side of the first pixel group (PG1). The second pixel group (PG2) may include fifth to eighth pixels (PX5-PX8). For example, the fifth to eighth pixels (PX5-PX8) may be arranged in a (2 × 2) matrix configuration. Each of the fifth to eighth pixels (PX5-PX8) may include a microlens (not shown) that converges incident light onto a photoelectric conversion region. Each of the fifth to eighth pixels (PX5-PX8) may include a color filter (not shown) that selectively transmits light (e.g., blue light) having a second wavelength range (e.g., 400 nm to 500 nm). The fifth to eighth pixels (PX5-PX8) may detect light of the second wavelength range. For example, each of the fifth to eighth pixels (PX5-PX8) may include a photoelectric conversion region that detects light of the second wavelength range.

The second pixel group (PG2) may be structurally similar or identical to the first pixel group (PG1) except that the second pixel group (PG2) detects light of a second wavelength range. Specifically, the wavelength range of light selectively transmitted by the color filter of the second pixel group (PG2) is different from the wavelength range of light selectively transmitted by the color filter of the first pixel group (PG1).

For example, the fifth pixel (PX5) may be structurally similar or identical to the first pixel (PX1) except that the wavelength range detected by the fifth pixel (PX5) is different from the wavelength range detected by the first pixel (PX1). The fifth pixel (PX5) may include a fifth active region (ACT5) and a fifth pixel isolation structure (ISO5) surrounding the fifth active region (ACT5). The fifth active region (ACTS) may include a photoelectric conversion region (not shown). The fifth pixel isolation structure (ISO5) may also surround the fifth photoelectric conversion region. The fifth pixel isolation structure (ISO5) may have a first width (W1).

The sixth pixel (PX6) may be structurally similar or identical to the second pixel (PX2) except for the wavelength range detected by the sixth pixel (PX6). The sixth pixel (PX6) may include a sixth active region (ACT6) and a sixth pixel isolation structure (ISO6) surrounding the sixth active region (ACT6). The sixth active region (ACT6) may include a photoelectric conversion region (not shown). The sixth pixel isolation structure (ISO6) may also surround the sixth photoelectric conversion region. The sixth pixel isolation structure (ISO6) may have a second width (W2).

The seventh pixel (PX7) may be structurally similar or identical to the third pixel (PX3) except for the wavelength range detected by the seventh pixel (PX7). The seventh pixel (PX7) may include a seventh active region (ACT7) and a seventh pixel isolation structure (ISO7) surrounding the seventh active region (ACT7). The seventh active region (ACT7) may include a photoelectric conversion region (not shown). The seventh pixel isolation structure (ISO7) may also surround the seventh photoelectric conversion region. The seventh pixel isolation structure (ISO7) may have a second width (W2).

The eighth pixel (PX8) may be structurally similar or identical to the fourth pixel (PX4) except for the wavelength range detected by the eighth pixel (PX8). The eighth pixel (PX8) may include an eighth active region (ACT8) and a eighth pixel isolation structure (ISO8) surrounding the eighth active region (ACT8). The eighth active region (ACT8) may include a photoelectric conversion region (not shown). The eighth pixel isolation structure (ISO8) may also surround the eighth photoelectric conversion region. The eighth pixel isolation structure (ISO8) may have a second width (W2).

The third pixel group (PG3) may contact the other side of the first pixel group (PG1). The third pixel group (PG3) may include ninth to twelfth pixels (PX9-PX12). For example, the ninth to twelfth pixels (PX9-PX12) may be arranged in a (2 × 2) matrix configuration. Each of the ninth to twelfth pixels (PX9-PX12) may include a microlens (not shown) that focuses incident light onto a photoelectric conversion region. Each of the ninth to twelfth pixels (PX9-PX12) may include a color filter (not shown) that selectively transmits light (e.g., red light) having a third wavelength range (e.g., 600 nm to 700 nm). The ninth to twelfth pixels (PX9-PX12) may detect light of the third wavelength range. For example, each of the ninth to twelfth pixels (PX9-PX12) may include a photoelectric conversion region that detects light of a third wavelength range.

The third pixel group (PG3) may be structurally similar or identical to the first pixel group (PG1) except that the third pixel group (PG3) detects light of a third wavelength range. The third pixel group (PG3) may be structurally similar or identical to the first pixel group (PG1) except that the wavelength range of light selectively transmitted by the color filter of the third pixel group (PG3) is different from the wavelength range of light selectively transmitted by the color filter of the first pixel group (PG1).

Hereinafter, overlapping descriptions will be omitted as much as possible.

For example, the ninth pixel (PX9) may be structurally similar or identical to the first pixel (PX1) except for the wavelength range detected by the ninth pixel (PX9). The tenth pixel (PX10) may be structurally similar or identical to the second pixel (PX2) except for the wavelength range detected by the tenth pixel (PX10). The eleventh pixel (PX11) may be structurally similar or identical to the third pixel (PX3) except for the wavelength range detected by the eleventh pixel (PX11). The twelfth pixel (PX12) may be structurally similar or identical to the fourth pixel (PX4) except for the wavelength range detected by the twelfth pixel (PX12).

The fourth pixel group (PG4) may contact each of the second pixel group (PG2) and the third pixel group (PG3). The fourth pixel group (PG4) may include the thirteenth to sixteenth pixels (PX13-PX16). For example, the thirteenth to sixteenth pixels (PX13-PX16) may be arranged in a (2 × 2) matrix configuration. Each of the thirteenth to sixteenth pixels (PX13-PX16) may include a microlens (not shown) that focuses incident light onto a photoelectric conversion region. Each of the thirteenth to sixteenth pixels (PX13-PX16) may include a color filter (not shown) that selectively transmits, for example, light (e.g., green light) in a first wavelength range or light (e.g., infrared light) in a fourth wavelength range (e.g., 700 nm or longer). Each of the thirteenth to sixteenth pixels (PX13-PX16) may include a photoelectric conversion region.

In one embodiment in which the fourth pixel group (PG4) includes a color filter that selectively transmits light of the first wavelength range, the fourth pixel group (PG4) may be structurally similar or identical to the first pixel group (PG1). In one embodiment in which the fourth pixel group (PG4) includes a color filter that selectively transmits light of the fourth wavelength range, the fourth pixel group (PG4) may be structurally similar or identical to the first pixel group (PG1) except that the fourth pixel group (PG4) detects light of the fourth wavelength range.

For example, the thirteenth pixel (PX13) may be structurally similar or identical to the first pixel (PX1). The fourteenth pixel (PX14) may be structurally similar or identical to the second pixel (PX2). The fifteenth pixel (PX15) may be structurally similar or identical to the third pixel (PX3). The sixteenth pixel (PX16) may be structurally similar or identical to the fourth pixel (PX4).

Each of the first to sixteenth pixel isolation structures (ISO1-ISO16) may be a part of one pixel isolation structure arranged along a boundary surface of pixels (PX) in the pixel array 130.

Each of the first to fourth pixel groups (PG1-PG4) may include pixels (PX1, PX5, PX9, PX13) with relatively low sensitivity and pixels (PX2-PX4, PX6-PX8, PX10-PX12, PX14-PX16) with relatively high sensitivity.

For example, the area (e.g., the area on the plan view) of each active region (ACT1, ACT5, ACT9, ACT13), which is a light reception region upon which incident light can be incident, in each of the pixels (PX1, PX5, PX9, PX13) each including a pixel isolation structure having the first width (W1) may be smaller than the area of each active region (ACT2-ACT4, ACT6-ACT8, ACT10-ACT12, ACT14-ACT16), which is a light reception region upon which incident light can be incident, in each of the pixels (PX2-PX4, PX6-PX8, PX10-PX12, PX14-PX16) each including a pixel isolation structure having a second width (W2). As the area of the active region decreases in size, the sensitivity of each pixel may decrease.

On the other hand, the area (e.g., the area on the plan view) of each pixel isolation structure (ISO1, ISO5, ISO9, ISO13) having the first width (W1) may be larger than the area of each pixel isolation structure (ISO2-ISO4, ISO6-ISO8, ISO10-ISO12, ISO14-ISO16) having the second width (W2).

Here, the boundary defining the area of each of the first to sixteenth pixels (PX1-PX16) may refer to, for example, the boundary of areas equally divided in a (4 × 4) matrix configuration, but a certain error may occur due to fabrication limitations or variables.

A fill factor of each pixel may refer to the ratio of an effective light reception area to a cross-sectional area of the entire pixel. The effective light reception area may refer to the area of the active region. For example, in a pixel having a cross-sectional area of a predetermined size, the fill factor may increase as the effective light reception area increases. The area of the active region may refer to the area excluding a blocking area upon which light is not incident from the cross-sectional area of the entire pixel. The blocking area may refer to, for example, a cross-sectional area of a pixel isolation structure or a cross-sectional area of a grid structure. As the fill factor increases, each pixel can detect more light. In addition, as the fill factor increases, more light can be collected, which can improve a signal-to-noise ratio (SNR) of each pixel.

In one embodiment of the disclosed technology, the cross-sectional areas of the first to sixteenth pixels (PX1-PX16) may be similar or identical to each other. The first pixel (PX1) has a smaller area of the active region than an area of the active region of the second to fourth pixels (PX2-PX4) and has a larger area of the pixel isolation structure than an area of the pixel isolation structure of each of the second to fourth pixels (PX2-PX4), so that the first pixel (PX1) may have a smaller fill factor than a fill factor of each of the second to fourth pixels (PX2-PX4). The fifth pixel (PX5) has a smaller area of the active region than an area of the active region of the sixth to eighth pixels (PX6-PX8) and has a larger area of the pixel isolation structure than an area of the pixel isolation structure of each of the sixth to eighth pixels (PX6-PX8), so that the fifth pixel (PX5) may have a smaller fill factor than a fill factor of each of the sixth to eighth pixels (PX6-PX8). The ninth pixel (PX9) has a smaller area of the active region than an area of the active region of the tenth to twelfth pixels (PX10-PX12) and has a larger area of the pixel isolation structure than an area of the pixel isolation structure of each of the tenth to twelfth pixels (PX10-PX12), so that the ninth pixel (PX9) may have a smaller fill factor than a fill factor of each of the tenth to twelfth pixels (PX10-PX12). The thirteenth pixel (PX13) has a smaller area of the active region than an area of the active region of the fourteenth to sixteenth pixels (PX14-PX16) and has a larger area of the pixel isolation structure than an area of the pixel isolation structure of each of the fourteenth to sixteenth pixels (PX14-PX16), so that the thirteenth pixel (PX13) may have a smaller fill factor than a fill factor for each of the fourteenth to sixteenth pixels (PX14-PX16).

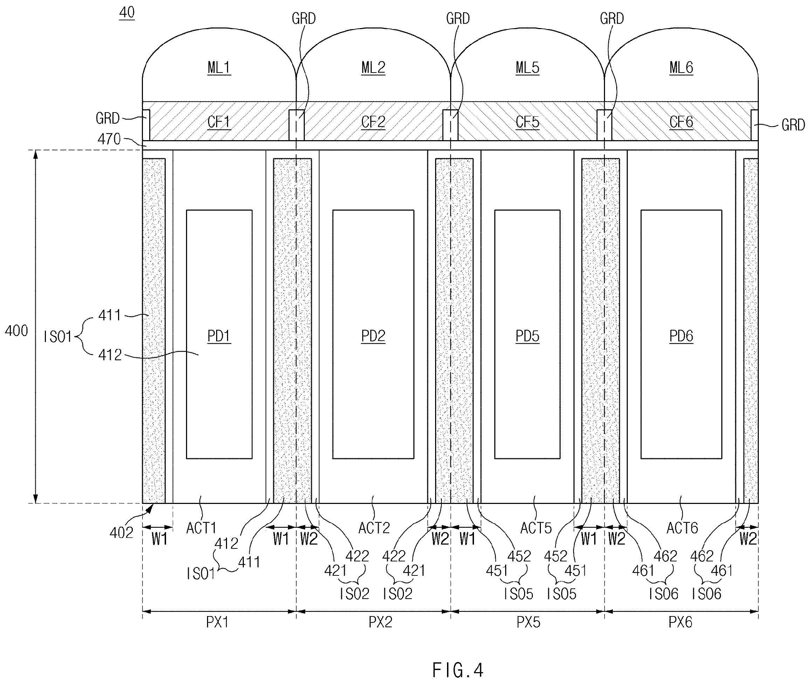

FIG. 4 is a cross-sectional view illustrating an example of the pixel region taken along the line A-A' shown in FIG. 3 based on some implementations of the disclosed technology.

Referring to FIGS. 3 and 4, the first cross-section 40 may include a first microlens (ML1), a second microlens (ML2), a fifth microlens (ML5), a sixth microlens (ML6), a first color filter (CF1), a second color filter (CF2), a fifth color filter (CF5), a sixth color filter (CF6), a grid structure (GRD), an anti-reflection layer 470, and a semiconductor layer 400.

The first microlens (ML1) may be arranged on the first color filter (CF1). The first microlens (ML1) may collect incident light received from the outside, and may transmit the collected light to the first color filter (CF1). For example, the first microlens (ML1) may include a material such as a light transmissive resin or a light transmissive photoresist.

The second microlens (ML2) may be arranged on the second color filter (CF2). The second microlens (ML2) may collect incident light received from the outside, and may transmit the collected light to the second color filter (CF2). The second microlens (ML2) may include the same material as the first microlens (ML1). In some implementations, the first color filter (CF1) and the second color filter (CF2) are of the same color.

The fifth microlens (ML5) may be arranged on the fifth color filter (CF5). The fifth microlens (ML5) may collect incident light received from the outside, and may transmit the collected light to the fifth color filter (CF5). The fifth microlens (ML5) may include the same material as the first microlens (ML1).

The sixth microlens (ML6) may be arranged on the sixth color filter (CF6). The sixth microlens (ML6) may collect incident light received from the outside, and may transmit the collected light to the sixth color filter (CF6). The sixth microlens (ML6) may include the same material as the first microlens (ML1). In some implementations, the fifth color filter (CF5) and the sixth color filter (CF6) are of the same color.

The first color filter (CF1) may selectively transmit light of a first wavelength range from among the incident light collected from the first microlens (ML1). The first color filter (CF1) may be disposed below the first microlens (ML1). The first color filter (CF1) may be disposed on the anti-reflection layer 470. The first color filter (CF1) may be disposed between the grid structures (GRDs).

The second color filter (CF2) may selectively transmit light of the first wavelength range from among the incident light collected from the second microlens (ML2). The second color filter (CF2) may be disposed below the second microlens (ML2). The second color filter (CF2) may be disposed on the anti-reflection layer 470. The second color filter (CF2) may be disposed between the grid structures (GRDs).

The fifth color filter (CF5) may selectively transmit light of a second wavelength range from among the incident light collected from the fifth microlens (ML5). The fifth color filter (CF5) may be disposed below the fifth microlens (ML5). The fifth color filter (CF5) may be disposed on the anti-reflection layer 470. The fifth color filter (CF5) may be disposed between the grid structures (GRDs).

The sixth color filter (CF6) may selectively transmit light of the second wavelength range from among the incident light collected from the sixth microlens (ML6). The sixth color filter (CF6) may be disposed below the sixth microlens (ML6). The sixth color filter (CF6) may be arranged on the anti-reflection layer 470. The sixth color filter (CF6) may be arranged between the grid structures (GRDs).

The grid structure (GRD) may be disposed on the anti-reflection layer 470. The grid structure (GRD) may be disposed at a boundary between two adjacent pixels (e.g., the first pixel PX1 and the second pixel PX2). For example, the grid structure (GRD) may be disposed at a boundary between two adjacent color filters (e.g., the first color filter CF1 and the second color filter CF2).

The grid structure (GRD) may prevent incident light obliquely received from the outside from being incident upon adjacent pixels, thereby reducing crosstalk between the adjacent pixels. The grid structure (GRD) may include a metal material (e.g., tungsten). The grid structure (GRD) may include an air region (not shown). In one embodiment in which the grid structure (GRD) includes the air region, the grid structure (GRD) may include an air region and a capping region defining the air region. The capping region may be a region surrounding the air region. The capping region may include a surface of the grid structure (GRD). The capping region may include a material having a lower refractive index than an adjacent color filter (e.g., the first color filter CF1). The grid structure (GRD) may be formed to penetrate the anti-reflection layer 470 based on another embodiment of the disclosed technology. In one example, the grid structure (GRD) may penetrate the anti-reflection layer 470 and come into contact with the pixel isolation structure.

In order to adjust the area of the active region, which is the light reception region upon which light is incident, by using the grid structure (GRD), the grid structure (GRD) needs to include a material with relatively high absorptivity, such as a metal (e.g., tungsten) or a barrier metal (e.g., titanium or titanium nitride). However, with respect to the grid structure (GRD) including the air region, a capping region surrounding the air region includes a material with low absorptivity and high reflectivity, so that it may be difficult for the capping region to adjust the area of the active region using the grid structure (GRD). However, when the width (or cross-sectional area) of the pixel isolation structures (ISO1, ISO2, ISO5, ISO6, etc.) is adjusted, the area of the active region may be designed differently for each pixel. In particular, as the area of the active region between pixels detecting light of the same wavelength range is different, the embodiments of the disclosed technology may provide the image sensing device including pixels of relatively low sensitivity to pixels of relatively high sensitivity so that the image sensing device can implement a high dynamic range (HDR). In addition, the embodiment in which the grid structure (GRD) includes the material with relatively high absorptivity may provide an image sensing device having a high dynamic range (HDR) because the area of the active region is different for each pixel by adjusting the width (or cross-sectional area) of each of the pixel isolation structures.

The anti-reflection layer 470 may be disposed on a back surface 401 of the semiconductor layer 400. The back surface 401 may mean a surface of the semiconductor layer 400 upon which incident light is incident. The anti-reflection layer 470 may include one or more layers having different refractive indices. The anti-reflection layer 470 may include a material having high light transmittance so that light of a specific wavelength that has passed through the color filter (CF1, CF2, CF5, or CF6) can be easily transferred to the photoelectric conversion region. For example, the anti-reflection layer 470 may include silicon oxide, silicon nitride, hafnium nitride, or the like.

The semiconductor layer 400 may include a first pixel isolation structure (ISO1), a second pixel isolation structure (ISO2), a fifth pixel isolation structure (ISO5), a sixth pixel isolation structure (ISO6), a first photoelectric conversion region (PD1), a second photoelectric conversion region (PD2), a fifth photoelectric conversion region (PD5), a sixth photoelectric conversion region (PD6), a first active region (ACT1), a second active region (ACT2), a fifth active region (ACTS), and a sixth active region (ACT6). The semiconductor layer 400 may include a back surface 401 and a front surface 402. The front surface 402 of the semiconductor layer 400 may be one surface of the semiconductor layer 400 facing or opposite to the back surface 401.

The first pixel isolation structure (ISO1) may be a structure that contacts the boundary of the first pixel (PX1) within the first pixel (PX1). The first pixel isolation structure (ISO1) may contact both sides of the first active region (ACT1). The first pixel isolation structure (ISO1) may include a first insulation layer 411 and a first conductive layer 412. The first insulation layer 411 may include an insulation material (e.g., silicon oxide, silicon nitride, etc.). The first conductive layer 412 may include a conductive material (e.g., polysilicon, doped polysilicon, etc.). The first pixel isolation structure (ISO1) may prevent light having penetrated the anti-reflection layer 470 from being incident upon a pixel (e.g., the second pixel PX2) adjacent to the first pixel (PX1).

The second pixel isolation structure (ISO2) may be a structure that contacts the boundary of the second pixel (PX2) within the second pixel (PX2). The second pixel isolation structure (ISO2) may contact both sides of the second active region (ACT2). The second pixel isolation structure (ISO2) may include a second insulation layer 421 and a second conductive layer 422. The second insulation layer 421 may include an insulation material (e.g., silicon oxide, silicon nitride, etc.). The second conductive layer 422 may include a conductive material (e.g., polysilicon, doped polysilicon, etc.). The second pixel isolation structure (ISO2) may prevent light having penetrated the anti-reflection layer 470 from being incident upon pixels (e.g., the first pixel PX1, the fifth pixel PX5) adjacent to the second pixel (PX2).

The second pixel isolation structure (ISO2) may contact the first pixel isolation structure (ISO1). The second insulation layer 421 may contact the first insulation layer 411. The second conductive layer 422 may contact the first conductive layer 412.

The fifth pixel isolation structure (ISO5) may be a structure that contacts the boundary of the fifth pixel (PX5) within the fifth pixel (PX5). The fifth pixel isolation structure (ISO5) may contact both sides of the fifth active region (ACT5). The fifth pixel isolation structure (ISO5) may include a fifth insulation layer 451 and a fifth conductive layer 452. The fifth insulation layer 451 may include an insulation material (e.g., silicon oxide, silicon nitride, etc.). The fifth conductive layer 452 may include a conductive material (e.g., polysilicon, doped polysilicon, etc.). The fifth pixel isolation structure (ISO5) may prevent light having penetrated the anti-reflection layer 470 from being incident upon pixels (e.g., the second pixel PX2, the sixth pixel PX6) adjacent to the fifth pixel (PX5).

The sixth pixel isolation structure (ISO6) may be a structure that contacts the boundary of the sixth pixel (PX6) within the sixth pixel (PX6). The sixth pixel isolation structure (ISO6) may contact both sides of the sixth active region (ACT6). The sixth pixel isolation structure (ISO6) may include a sixth insulation layer 461 and a sixth conductive layer 462. The sixth insulation layer 461 may include an insulation material (e.g., silicon oxide, silicon nitride, etc.). The sixth conductive layer 462 may include a conductive material (e.g., polysilicon, doped polysilicon, etc.). The sixth pixel isolation structure (ISO6) may prevent light having penetrated the anti-reflection layer 470 from being incident upon a pixel (e.g., the fifth pixel PX5) adjacent to the sixth pixel (PX6).

The sixth pixel isolation structure (ISO6) may contact the fifth pixel isolation structure (ISO5). The sixth insulation layer 461 may contact the fifth insulation layer 451. The sixth conductive layer 462 may contact the fifth conductive layer 452.

The width of each of the first and fifth pixel isolation structures (ISO1, ISO5) may be the first width (W1). The width of each of the second and sixth pixel isolation structures (ISO2, ISO6) may be the second width (W2).

The first active region (ACT1) may surround the first photoelectric conversion region (PD1). The first active region (ACT1) may be a semiconductor region including impurities of the first conductivity type (e.g., P-type).

The second active region (ACT2) may surround the second photoelectric conversion region (PD2). The second active region (ACT2) may be a semiconductor region including impurities of the first conductivity type.

The fifth active region (ACT5) may surround the fifth photoelectric conversion region (PD5). The fifth active region (ACT5) may be a semiconductor region including impurities of the first conductivity type.

The sixth active region (ACT6) may surround the sixth photoelectric conversion region (PD6). The sixth active region (ACT6) may be a semiconductor region including impurities of the first conductivity type.

The first photoelectric conversion region (PD1) may be a region that generates photocharges in response to light having penetrated the first color filter (CF1). The first photoelectric conversion region (PD1) may be a semiconductor region including impurities of a second conductivity type (e.g., N-type).

The second photoelectric conversion region (PD2) may be a region that generates photocharges in response to light having penetrated the second color filter (CF2). The second photoelectric conversion region (PD2) may be a semiconductor region including impurities of the second conductive type.

The fifth photoelectric conversion region (PD5) may be a region that generates photocharges in response to light having penetrated the fifth color filter (CF5). The fifth photoelectric conversion region (PD5) may be a semiconductor region including impurities of the second conductive type.

The sixth photoelectric conversion region (PD) may be a region that generates photocharges in response to light having penetrated the sixth color filter (CF6). The sixth photoelectric conversion region (PD6) may be a semiconductor region including impurities of the second conductive type.

A cross-section of the structure taken along the line A"-A"' of FIG. 3 may appear substantially the same as the first cross-section 40.

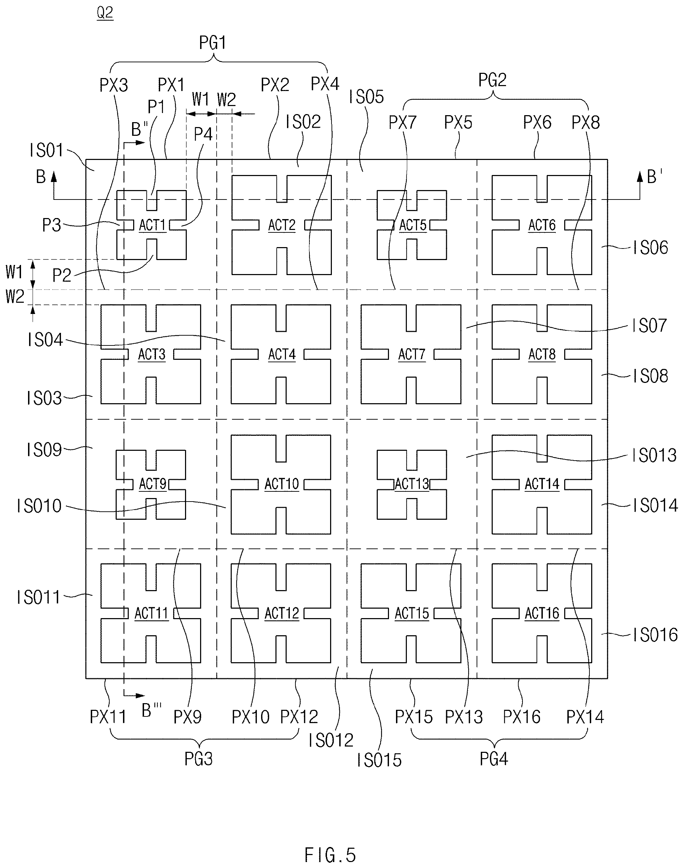

FIG. 5 is a circuit diagram illustrating a second embodiment of the pixel region shown in FIG. 2 based on some implementations of the disclosed technology.

Referring to FIGS. 2, 3 and 5, the pixel region (Q1) based on an embodiment may include first to fourth pixel groups (PG1-PG4). The first to fourth pixel groups (PG1-PG4) may be arranged in a (2 × 2) matrix configuration.

Hereinafter, descriptions overlapping with those in FIG. 3 will be omitted as much as possible, and the second embodiment of FIG. 5 will hereinafter be described with a focus on the characteristics that are different from those of the first embodiment.

Each of the first to fourth pixels (PX1-PX4) included in the first pixel group (PG1) may include a color filter that selectively transmits light of the first wavelength range. Each of the fifth to eighth pixels (PX5-PX8) included in the second pixel group (PG2) may include a color filter that selectively transmits light of the second wavelength range. Each of the ninth to twelfth pixels (PX9-PX12) included in the third pixel group (PG3) may include a color filter that selectively transmits light in a third wavelength range. Each of the thirteenth to sixteenth pixels (PX13-PX16) included in the fourth pixel group (PG4) may include a color filter that selectively transmits light of a first wavelength range (or light of a fourth wavelength range).

The first pixel (PX1) may include a first active region (ACT1) and a first pixel isolation structure (ISO1) surrounding the first active region (ACT1). The first pixel isolation structure (ISO1) may be formed to extend from the boundary of the first pixel (PX1) to the inside of the first pixel (PX1) by a first width (W1). The first pixel isolation structure (ISO1) may be arranged along the boundary of the first pixel (PX1) to surround the first active region (ACT1).

The first pixel isolation structure (ISO1) may include a first protrusion (P1), a second protrusion (P2), a third protrusion (P3), and a fourth protrusion (P4). Each of the first to fourth protrusions (P1-P4) may extend to the inside of the first pixel (PX1). The width of each of the protrusions (P1-P4) is not limited to a specific range. The first protrusion (P1) and the second protrusion (P2) may extend in directions facing each other. The third protrusion (P3) and the fourth protrusion (P4) may extend in directions facing each other.

The first active region (ACT1) may include first to fourth photoelectric conversion regions (not shown) different from each other. The first to fourth photoelectric conversion regions may be arranged in a (2 × 2) matrix configuration. A protrusion may be arranged between each of the first photoelectric conversion regions and each of the fourth photoelectric conversion regions. For example, the first protrusion (P1) may be disposed between the first and second photoelectric conversion regions. The second protrusion (P2) may be disposed between the third and fourth photoelectric conversion regions. The third protrusion (P3) may be disposed between the first and third photoelectric conversion regions. The fourth protrusion (P4) may be disposed between the second and fourth photoelectric conversion regions. The first to fourth protrusions (P1, P2, P3, P4) may be spaced apart from each other.

Each of the second to sixteenth pixel isolation structures (ISO2-ISO16) may include four different protrusions. Each of the second to sixteenth active regions (ACT2-ACT16) may also include four different photoelectric conversion regions. The photoelectric conversion regions may be spaced apart from each other with a protrusion interposed therebetween.

Since the first active region (ACT1) is smaller than each of the second to fourth active regions (ACT2-ACT4), the sensitivity of the first pixel (PX1) may be lower than the sensitivity of each of the second to fourth pixels (PX2-PX4).

For the same reason, the sensitivity of the fifth pixel (PX5) may be lower than the sensitivity of each of the sixth to eighth pixels (PX6-PX8), the sensitivity of the ninth pixel (PX9) may be lower than the sensitivity of each of the tenth to twelfth pixels (PX10-PX12), and the sensitivity of the thirteenth pixel (PX13) may be lower than the sensitivity of each of the fourteenth to sixteenth pixels (PX14-PX16).

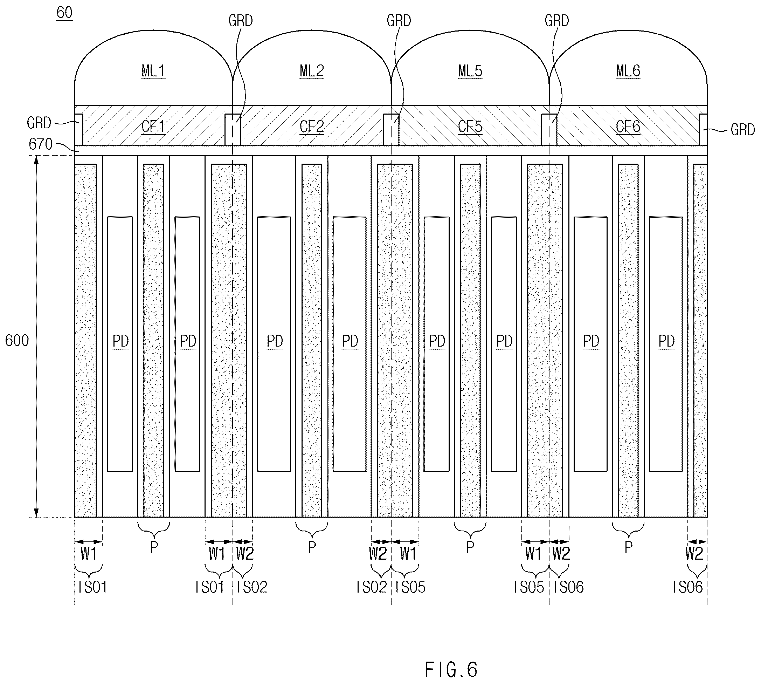

FIG. 6 is a cross-sectional view illustrating an example of the pixel region taken along the line B-B' shown in FIG. 5 based on some implementations of the disclosed technology.

Referring to FIGS. 4 to 6, the second cross section 60 may include a first microlens (ML1), a second microlens (ML2), a fifth microlens (ML5), a sixth microlens (ML6), a first color filter (CF1), a second color filter (CF2), a fifth color filter (CF5), a sixth color filter (CF6), a grid structure (GRD), an anti-reflection layer 670, and a semiconductor layer 600.

Hereinafter, descriptions overlapping with FIG. 4 will be omitted.

A protrusion (P) may be arranged at the center of the first active region (ACT1). The protrusion (P) may have substantially the same cross-section as the pixel isolation structure, but is not limited thereto. For example, the width of the protrusion (P) may be different from each of the first width (W1) and the second width (W2). Different photoelectric conversion regions (PD) may be arranged within the first active region (ACT1) with the protrusion (P) interposed therebetween.

A protrusion (P) may be arranged at the center of each of the second active region (ACT2), the fifth active region (ACTS), and the sixth active region (ACT6), and may have substantially the same cross-section as the pixel isolation structure, but is not limited thereto. Different photoelectric conversion regions (PD) may also be arranged with the protrusion (P) interposed therebetween for each of the second, fifth, and sixth active regions (ACT2, ACT5, ACT6).

The anti-reflection layer 670 may be substantially the same as the anti-reflection layer 470 described with reference to FIG. 4.

A cross-section of the structure taken along the line B"-B"' of FIG. 5 may appear substantially the same as the second cross-section 60.

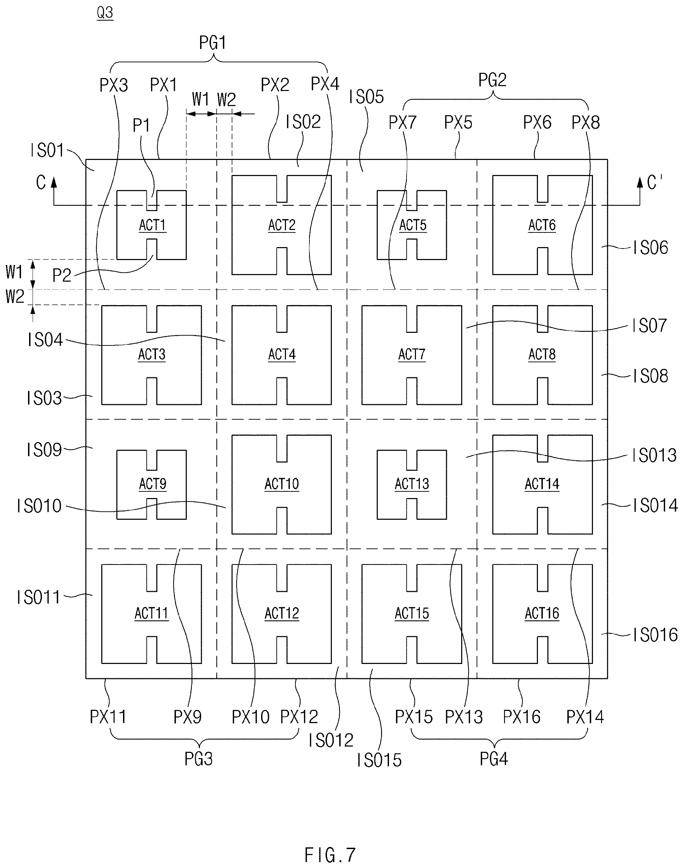

FIG. 7 is a circuit diagram illustrating a third embodiment of the pixel region shown in FIG. 2 based on some implementations of the disclosed technology.

Referring to FIGS. 2, 3, 5, and 7, the pixel region (Q3) based on an embodiment may include first to fourth pixel groups (PG1-PG4). The first to fourth pixel groups (PG1-PG4) may be arranged in a (2 × 2) matrix configuration.

Hereinafter, descriptions overlapping with those in FIG. 3 will be omitted as much as possible, and the third embodiment of FIG. 7 will hereinafter be described with a focus on the characteristics that are different from those of the second embodiment.

Each of the first to fourth pixels (PX1-PX4) included in the first pixel group (PG1) may include a color filter that selectively transmits light of the first wavelength range. Each of the fifth to eighth pixels (PX5-PX8) included in the second pixel group (PG2) may include a color filter that selectively transmits light of a second wavelength range. Each of the ninth to twelfth pixels (PX9-PX12) included in the third pixel group (PG3) may include a color filter that selectively transmits light of a third wavelength range. Each of the thirteenth to sixteenth pixels (PX13-PX16) included in the fourth pixel group (PG4) may include a color filter that selectively transmits light of a first wavelength range (or light of a fourth wavelength range).

The first pixel (PX1) may include a first active region (ACT1) and a first pixel isolation structure (ISO1) surrounding the first active region (ACT1). The first pixel isolation structure (ISO1) may be formed to extend from the boundary of the first pixel (PX1) to the inside of the first pixel (PX1) by a first width (W1). The first pixel isolation structure (ISO1) may be disposed along the boundary of the first pixel (PX1) to surround the first active region (ACT1).

The first pixel isolation structure (ISO1) may include first and second protrusions (P1, P2). Each of the first and second protrusions (P1, P2) may extend to the inside of the first pixel (PX1). The width of each of the first and second protrusions (P1, P2) is not limited to a specific range. The first and second protrusions (P1, P2) may extend in directions facing each other.

The first active region (ACT1) may include first and second photoelectric conversion regions (not shown) that are different from each other. The first and second protrusions (P1, P2) may be disposed between each of the first photoelectric conversion regions and each of the second photoelectric conversion regions. The first and second protrusions (P1, P2) may extend from the first pixel isolation structure (ISO1) toward each other in the space between the first and second photoelectric conversion regions. The first and second protrusions (P1, P2) may be spaced apart from each other.

Each of the second to sixteenth pixel isolation structures (ISO2-ISO16) may include two different protrusions. Each of the second to sixteenth active regions (ACT2-ACT16) may also include two different photoelectric conversion regions. The photoelectric conversion regions may be spaced apart from each other with a protrusion interposed therebetween.

A cross-section of the structure taken along the line C-C' of FIG. 7 may appear substantially the same as the second cross-section 60.

As is apparent from the above description, the image sensing device based on some embodiments of the disclosed technology may enable pixels that detect light beams of the same wavelength range to have different sensitivities without designing a separate complex circuit, resulting in implementation of a high dynamic range (HDR).

The embodiments of the disclosed technology may provide a variety of effects capable of being directly or indirectly recognized through the above-mentioned patent document.

Although a number of illustrative embodiments have been described, it should be understood that modifications and enhancements to the disclosed embodiments and other embodiments can be devised based on what is described and/or illustrated in this patent document.

## Claims

1. An image sensing device comprising:
a first pixel including:
a first photoelectric conversion region configured to generate electrical signals in response to detecting light of a first wavelength range; and
a first pixel isolation structure that surrounds the first photoelectric conversion region and has a first width; and
a second pixel including:
a second photoelectric conversion region configured to generate electrical signals in response to detecting light of the first wavelength range, and
a second pixel isolation structure that surrounds the second photoelectric conversion region and has a second width smaller than the first width.

2. The image sensing device according to claim 1, further comprising:
a grid structure disposed on the first and second pixel isolation structures along a boundary between the first pixel and the second pixel,
wherein
the first and second pixel isolation structures are in contact with each other,
the first pixel includes a first color filter configured to selectively transmit incident light of the first wavelength range; and
the second pixel includes a second color filter configured to selectively transmit incident light of the first wavelength range,
wherein
the grid structure is disposed between the first color filter and the second color filter.

3. The image sensing device according to claim 2, wherein:
the grid structure includes an air region.

4. The image sensing device according to claim 1, further comprising:
a third pixel including
a third photoelectric conversion region configured to generate electrical signals in response to detecting light of a second wavelength range, and
a third pixel isolation structure that surrounds the third photoelectric conversion region and has the second width; and
a fourth pixel including
a fourth photoelectric conversion region configured to generate electrical signals in response to detecting light of the first wavelength range, and
a fourth pixel isolation structure that surrounds the fourth photoelectric conversion region and has the second width.

5. The image sensing device according to claim 4,
wherein the first pixel further comprises:
a fifth photoelectric conversion region configured to generate electrical signals in response to detecting light of the first wavelength range; and
a first protrusion disposed between the first photoelectric conversion region and the fifth photoelectric conversion region and extending toward a center portion of the first pixel from the first pixel isolation structure in a first direction
wherein the second pixel further comprises:
a sixth photoelectric conversion region configured to generate electrical signals in response to detecting light of the second wavelength range; and
a second protrusion disposed between the second photoelectric conversion region and the six photoelectric conversion region and extending toward a center portion of the second pixel from the second pixel isolation structure.

6. The image sensing device according to claim 5, wherein the first pixel further comprises:
Seventh and eighth photoelectric conversion regions configured to generate electrical signals in response to detecting light of the first wavelength range;
a third protrusion extending toward a center portion of the second pixel from the second pixel isolation structure in a second direction opposite to the first direction and disposed between the first photoelectric conversion region and the seventh photoelectric conversion region;
a fourth protrusion extending toward a center portion of the second pixel from the second pixel isolation structure in a third direction perpendicular to the first direction and disposed between the fifth photoelectric conversion region and the eighth photoelectric conversion region; and
a fifth protrusion extending toward a center portion of the second pixel from the second pixel isolation structure in a second direction opposite to the third direction and disposed between the seventh photoelectric conversion region and the eighth photoelectric conversion region.

7. The image sensing device according to claim 4, wherein:
the first pixel has a lower sensitivity in sensing light than a sensitivity in sensing light of each of the second to fourth pixels.

8. An image sensing device comprising:
a first pixel group including first and second pixels configured to generate electrical signals in response to detecting light of a first wavelength range,
wherein
the first pixel includes a first pixel isolation structure surrounding a first active region upon configured to receive incident light of the first wavelength range; and
the second pixel includes a second pixel isolation structure surrounding a second active region configured to receive incident light of the first wavelength range,
wherein
the second pixel isolation structure has a smaller area than an area of the first pixel isolation structure.

9. The image sensing device according to claim 8, wherein:
the second active region has a larger area than an area of the first active region.

10. The image sensing device according to claim 8, wherein:
the second pixel has a higher fill factor than a fill factor of the first pixel.

11. The image sensing device according to claim 8, wherein:
the first pixel further includes:
a first protrusion extending from the first pixel isolation structure toward a center of the first pixel in a first direction; and
the second pixel further includes:
a second protrusion extending from the second pixel isolation structure toward a center of the second pixel in the first direction.

12. The image sensing device according to claim 11, wherein:
the first pixel further includes:
a third protrusion extending from the first pixel isolation structure toward the center of the first pixel in a second direction; and
the second pixel further includes:
a second protrusion extending from the second pixel isolation structure toward the center of the second pixel in the second direction.

13. The image sensing device according to claim 8, wherein:
the first pixel group further includes third and fourth pixels configured to generate electrical signals in response to detecting light of the first wavelength range,
wherein
the third pixel includes a third pixel isolation structure configured to surround a third active region configured to receive incident light of the first wavelength range; and
the fourth pixel includes a fourth pixel isolation structure configured to surround a fourth active region configured to receive incident light of the first wavelength range,
wherein
each of the third and fourth pixel isolation structures has a smaller area than an area of the first pixel isolation structure.

14. The image sensing device according to claim 13, further comprising:
a second pixel group including fifth and sixth pixels configured to generate electrical signals in response to detecting light of a second wavelength range and configured to be in contact with the first pixel group,
wherein
the fifth pixel includes a fifth pixel isolation structure surrounding a fifth active region configured to receive incident light of the second wavelength range; and
the sixth pixel includes a sixth pixel isolation structure surrounding a sixth active region configured to receive incident light of the second wavelength range,
wherein
the sixth pixel isolation structure has a smaller area than an area of the fifth pixel isolation structure.

15. The image sensing device according to claim 14, wherein:
the sixth active region has a larger area than an area of the fifth active region.
